**Europäisches Patentamt**

(19) **European Patent Office**

**Office européen des brevets**

(11) Publication number : **0 233 814 B1**

(12) # EUROPEAN PATENT SPECIFICATION

(45) Date of publication of patent specification :
02.10.91 Bulletin 91/40

(51) Int. Cl.⁵ : **H05K 7/20, H05K 7/18, H01R 23/68**

(21) Application number : 87400183.7

(22) Date of filing : 27.01.87

(54) **A rack for circuit boards of an electronic system.**

(30) Priority : 28.01.86 US 823387

(43) Date of publication of application :
26.08.87 Bulletin 87/35

(45) Publication of the grant of the patent :
02.10.91 Bulletin 91/40

(84) Designated Contracting States :
AT BE CH DE ES FR GB GR IT LI LU NL SE

(56) References cited :
EP-A- 0 068 195
WO-A-85/02499
CH-A- 421 228
FR-A- 2 341 248
GB-A- 1 128 939
US-A- 3 967 874
US-A- 4 047 782
US-A- 4 489 363
SOVIET INVENTIONS ILLUSTRATED, Week
K14, Section Mechanical, 18th May 1983, ab-
stract no. E6580 K 14, Derwent Publications
Ltd., London, GB; & SU - A - 930 781

(73) Proprietor : DIGITAL EQUIPMENT
CORPORATION
146 Main Street
Maynard, MA 01754 (US)

(72) Inventor : Schmidt, William L.
10 Wampanoag Drive
Acton Masachusetts 01720 (US)
Inventor : Olson, Richard E.
85 Maplewood Drive
Townsend Massachusetts 01469 (US)
Inventor : Bailey, Douglas A.
121 Everett Street
Concord Massachusetts 01742 (US)

(74) Representative : Mongrédien, André et al
c/o SOCIETE DE PROTECTION DES
INVENTIONS 25, rue de Ponthieu
F-75008 Paris (FR)

## Description

This invention relates to a supporting structure for printed circuit boards and the like and more particularly to a rack, often called a "card cage", for electronic systems, that occupies a minimum space, and yet promotes ease of installation, maintenance and replacement of the boards and promotes substantially uniform air flow over said boards.

## Background of the Invention

The physical size of electronic systems has been the subject of a substantial development effort for a number of years. The space occupied by such systems has decreased markedly, as a result of a dramatic reduction in the size and power dissipation of the various components that make up the system. In particular, the large-scale integration of the circuitry of such systems has materially reduced the aggregate physical volume of the components of a system.

Even so, the "packaging" of these components in a minimum physical volume remains a challenge to the designers of these systems. As the volume decreases, one encounters increased difficulties and expenses in maintenance and repair due to the limited space and greater concentration of components within such systems. Further, the extraction of internally generated heat becomes more difficult, a significant problem in view of the temperatures limits that must be maintained for reliable performance of the various components of such systems. This problem appears into several structures for printed circuit boards disclosed in the prior art and more particularly in the structure described in tyre document CH-A-421 228. In this document, the structure disclosed does not comprise paths sized so as to have particular coolant flow characteristics.

In general, groups of components which are functionally related are mounted on separate circuit boards. Thus, by choosing among a number of different boards, one may organize a system having the desired set of functional capabilities. The requirements of individual users are varied and a need has developed for "packaging" the circuit boards which permits the inclusion of different combinations of such circuit boards without materially degrading the heat extraction characteristics of the structure.

## Summary of the Invention

It is therefore an object of the invention to provide an improved structure for housing circuit boards of an electronic system in a relatively small physical volume.

Another object is to provide such a structure with improved air flow characteristics which permit substantially uniform cooling flow to the various circuit boards of such systems housed therein.

Another object is to provide such structures with improved air flow characteristics which promote for substantially uniform cooling flow to various circuit boards of such systems housed therein when the structures are arranged in parallel.

Another object is to provide an improved structure which promotes substantially uniform cooling flow to various circuit boards of such systems housed therein without being restricted to particular arrangements of such circuitry.

A rack embodying the invention incorporates a frame having four sides and a back panel. Two of the opposite sides are grilles. The frame is adapted for supporting printed circuit boards perpendicular to the grilles. Thus, a fluid cooling medium, such as air, can enter the rack through one of the grilles, flow along and between the circuit boards and exit through the other grilles. The flow of such air for cooling can be generated in any known manner, such as by the action of a fan. Thus, internally generated heat in various components positioned on the boards can be readily dissipated by the air flow over the components. The grilles are constructed, as set forth below, to promote a uniform coolant flow for each of the circuit boards in the rack.

The rack has a lever assembly which remotely actuates connectors positioned in the rack to contact the circuit boards positioned therein. The lever assembly is further provided with a spring member which serves as a force-limiting device such that excessive force is not applied to the boards and to the connectors when the boards are inserted into the rack. Thus, the rack is adapted so that the boards are installed, replaced, and rearranged easily.

The rack also has guide members for guiding warped circuit boards into position.

The invention is directed to a rack for mounting circuit boards having side panels and a back panel for use in electronic systems having means for generating a coolant flow through said rack, said rack further comprising :

- a top grille, being connected to the top of the side panels and the back panel,
- a bottom grille, being connected to the bottom of the side panels and the back panel, whereby said grilles, the side panels and the back panel form a frame having a rectangular cross-section,
- said grilles having means for positioning a plurality of circuit boards between said grille in a manner perpendicular to the grilles,
- said grilles having apertures positioned therein to permit the passage of the coolant flow, generated by the means for generating a coolant flow, through said rack and between circuit boards positioned in the rack,
- said apertures being of such size and shape that the combined coolant flow impedance of the apertures is substantially greater than the coolant flow impedance of the circuit boards positioned therein, whereby the coolant flow through the rack is substantially independent of the arrangement of circuit boards within the rack.

Brief Description of the Drawings

For a fuller understanding of the nature ans object of the invention, reference should be had to the following detailed description taken in connection with the accompanying drawings in which:

FIG. 1 is a perspective view, from the top, of a rack embodying the invention, constructed to support a set of circuit boards or the like;

FIG. 1a is a top view of the rack of FIG. 1;

FIG. 1b is a side view of the rack of FIG. 1;

FIG. 1c is a front view of the rack of FIG. 1;

FIG. 2 is a perspective view, from the rear, of the rack of FIG. 1;

FIG. 3 is a top view of the bottom grille of the rack;

FIG. 3a is a sectional view of the grille of FIG. 3 taken along section line 3a;

FIG. 3b is a sectional view of the grille of FIG. 3 taken along section line 3b;

FIG. 4 is a bottom view of the top grille of the rack;

FIG. 5 is a perspective view of a rear panel of the rack;

FIG. 5a is a partial sectional view of the rear panel of FIG. 5 taken along section line 5a;

FIG. 5b is a partial sectional view of the rear panel of FIG. 5 taken along section line 5b;

FIG. 5c is a view of alternative component of the present invention for mounting to the frame of the rear panel of FIG. 5;

FIG. 6 is a partly exploded top view of an actuator assembly component of the rack; and

FIG. 6a is a partly exploded side view of the assembly of FIG. 6.

Detailed Description of the Preferred Embodiments

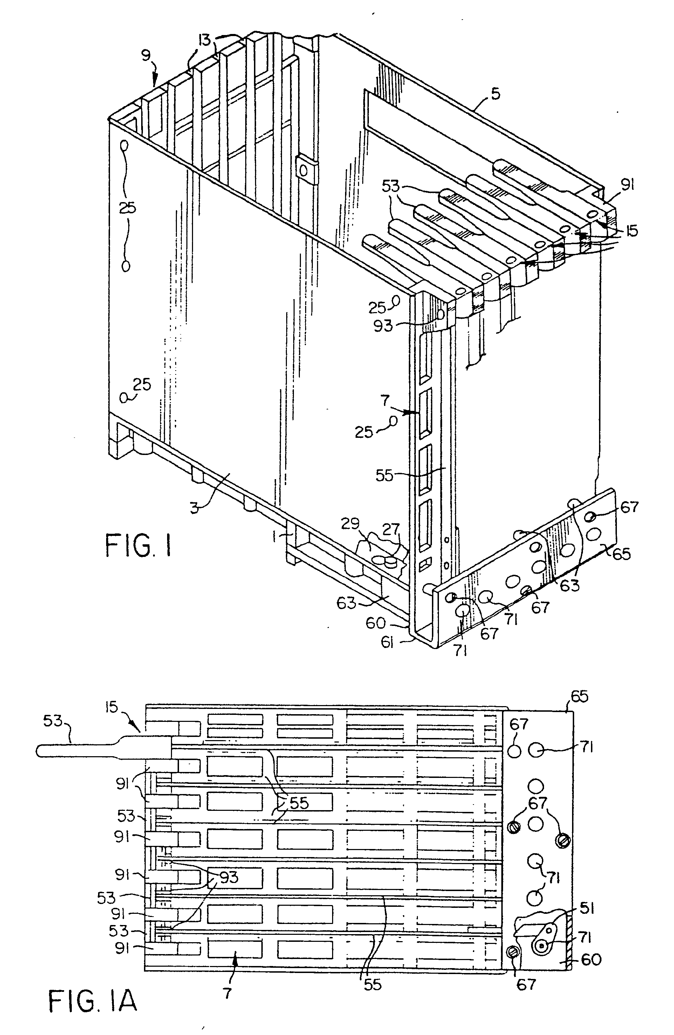

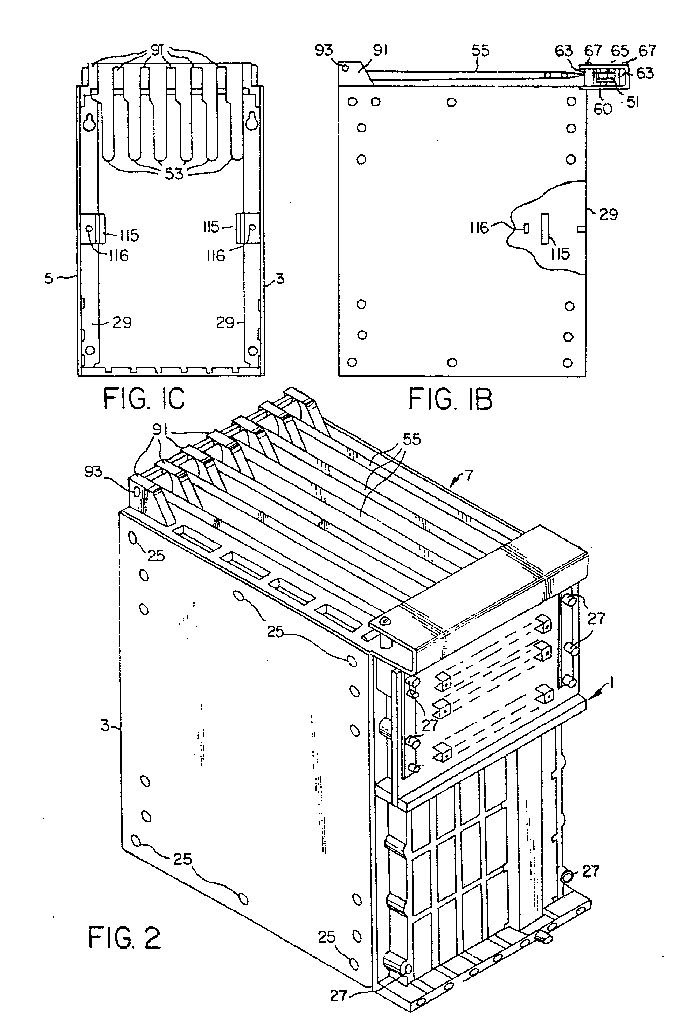

Referring now to FIGS. 1 and 2 a rack for printed circuit boards of an electronic system, such as a data processing system, comprises a back panel 1, left and right side panels 3 and 5, respectively, a top grille 7, and a bottom grille 9.

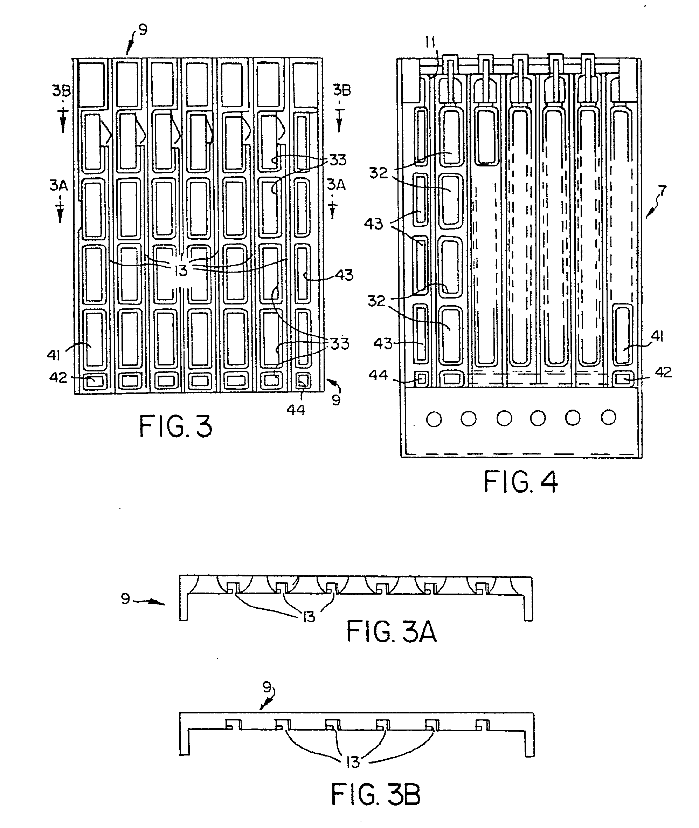

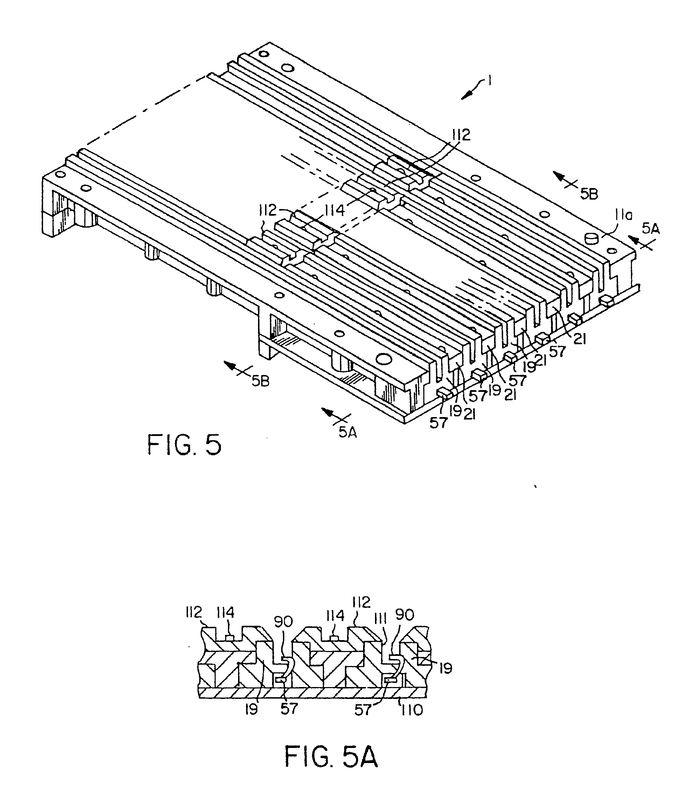

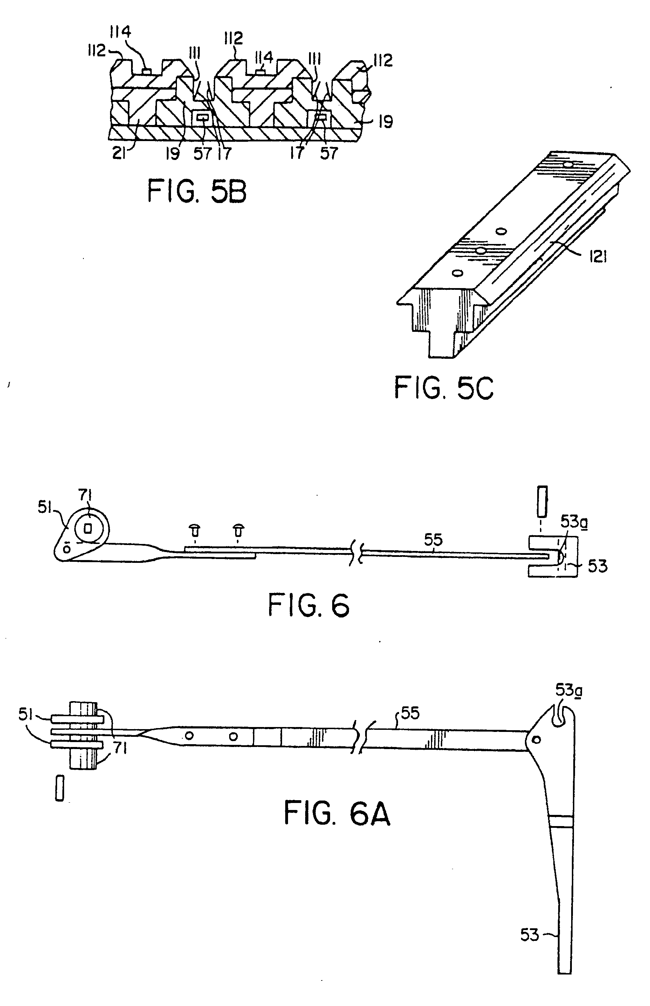

The grilles 7 and 9 are formed with opposing tracks 11 and 13 (see FIGS. 3 and 4) respectively, which are sized to receive the edges of printed circuit boards (not shown). Lever assemblies 15, secured to the front grille 7, actuate connectors 17 (FIG. 5B) positioned in the back panel 1 to contact conductors on the printed circuit boards positioned in the tracks 11 and 13.

With reference to FIG. 5, the back panel 1 includes brackets 19 which are mounted thereon by T-shaped bars 21 secured to the back panel 1.

With further reference to FIGS. 1 and 2, the top and bottom grilles 7 and 9 are secured to the side panels 3 and 5 by suitable means such as rivets 25. The back panel 1 is mounted by screws 27 on brackets 29, which extend inwardly from the panels 3 and 5.

Referring now to FIG. 3 and 4, the grilles 7 and 9 are shown with corresponding rows of apertures 32 and 33 (for clarity, only one row of each of the apertures 32 and 33 have been numbered) which are disposed on both sides of each of the tracks 11 and 13, respectively. Thus, air or another cooling medium may be moved through the rack by a blower, fan or other suitable means. The corresponding rows of apertures of the grilles 7 and 9 are sized to have a combined air flow impedance which is substanially greater than the impendance provided by the circuit boards positioned within the rack. Thus, the substitution of different boards in the rack or even the absence of boards therefrom, does not unduly change the air flow through the rows of apertures 32 and 33.

The rack in this instance is sized to receive circuit boards having an approximate height and length of 22,86 cm (9 inches) and 20,32 cm (8 inches), respectively; the illustrated rack is adapted to receive six boards each having a thickness of approximately 0,23 cm (3/32 inche). With boards that dissipate up to 50 watts each and with subcomponents extending up to about 1,27 cm (1/2 inch) from the surface of any of the boards, Applicants have found that the following dimensions of the apertures 32 and 33 and the spaces between them in the grilles 7 and 9, as shown in FIGS. 3 and 4, are appropriate:

the large sized apertures, such as the apertures at 41, have a length of 3,17 cm (1 1/4 inch ) and a width of 0,95 cm (3/8 inch ) ;

the smaller sized apertures, such as the apertures at 42, have a length of 0,63 cm (1/4 inch ) and a width of 0,95 cm (3/8 inch ) ;

the half-sized large apertures , such as the apertures at 43, have a length of 3, 17 cm (1 1/4 inch ) and a width of 0,47 cm (3/16 inch ) ;

the half-sized smaller apertures, denoted at 44, have a length of 0, 63 cm (1/4 inch) and a width of 0,47 cm (3/16 inch ) ;

the solid portions of the grilles 7 and 9, disclosed between each of the rows 32 and 33, have a width of 1, 03 cm (13/32 inch ) ; and

the solid portions of the grilles 7 and 9, disposed between the apertures in each of the rows 32 and 33, have a length of 0, 63 cm (1/4 inch).

Each of the apertures is further provided with contoured sides forming a vena contracta for air entering the aperture and a nozzle for air exiting the aperture. Thus, uniform air flow, without appreciable turbulance generated thereby, enters through the apertures 32, in this case, and passes by any circuit boards positioned in the tracks 11 and 13 adjacent thereto to exit through apertures 33.

Thus, it will be appreciated by those skilled in the art that the above described rack has wide applications to systems using circuit boards and having a forced-flow cooling system in either direction, because the arrangement of grilles 7 and 9 is for flow analysis identical in both directions. The system also permits the rearrangement of boards within the rack without regard for cooling consequences, since the air flow along the boards remains substantially unchanged with respect to the presence, absence or arrangement of other boards within the rack. Applicants have found with the above described example that the maximum variation in flow is on the order of 35% change between a row 32 and 33 having no circuit boards disposed in the adjacent tracks 11 and 13 and a row having boards disposed in both sets of adjacent tracks 11 and 13.

Moreover, series of these racks may be used in parallel arrangements without concern as to the various arrangements of modules within a particular rack; and the arrangements of the modules between the parallelly arrange racks, since the impedances are no significantly different between such racks.

With reference now to FIGS. 1a, 1b, and 1c, crank arms 51 are connected to levers 53 by links 55. The crank arms 51 are also connected to said connectors 17 by keyed shafts 57 (FIG. 5) which extend from said back panel 1.

Rotation of the shafts 57 moves the connectors 17 from a first position in contact with circuit boards positioned in the bracket 19 associated with the connector 17 to a second position away from the board. Thus, the movement of the levers 53 from the closed position shown in FIG. 1c to the open position away from the rack, as shown by one of the levers 53 in FIG. 1a, causes the links 55 to urge the rotation of the keyed shafts 57 and, therefore, the movement of the connectors 17 from their first to second positions.

As shown in FIG. 1, the top grille 7 has a rearward extension 60 that extends over said back panel 1 and an upwardly extending portion 61 at the outer edge of the extension 60. Centrally threaded cylindrical posts 63 extend from the rearward extension 60. A cover panel 65 is supported on the posts 63 by screws 67.

With reference to FIGS. 1a, 1b, 6a, and 6b, a set of actuator shafts 71 are disposed for rotation in holes in the cover panel 65 and the rearward extension 61 of the top grille 7. The crank arms 51 are affixed to the shafts 71 for rotation of the latter, as described below. The crank arms also serve to maintain the vertical positions of the shafts. The bottom ends of the shafts 71 are recessed, as shown in FIG. 6, to receive keyed shafts 57 extending from the connectors 17. Thus, rotation of the shafts 71, by means of the crank arms 51, opens and closes the connectors in a conventional fashion.

The crank arms 51 are rotated by means of the levers 53 at the front of the rack. Specifically, as shown in FIG. 6a, each of the levers has a pivot connection to one end of each of the flexible links 55 which, at its other end, is pivotaly connected to one of the crank arms 51 (FIG. 6). The lever 53 also has an aperture 53a by which it is pivotaly supported on a shaft 93 (FIGS. 1b and 2) supported in a series of projections 91 that extend upwardly from the front portion of the grille 7. The projections 91 are located so as to position each of the levers 53 in front of one of each set of the tracks 11 and 13 in which circuit boards are positionable, as shown in FIG. 1c.

With the foregoing arrangement, when a lever 53 is rotated from the position shown in FIG. 1c to the horizontal position shown by one of the levers 53 in FIG. 1a, the link 55 connected thereto is pulled toward the front of the rack. The resulting rotation of the crank arm 51 and the shaft 71 opens the corresponding connector for insertion or removal of a circuit board. When one of the levers 53 is rotated from the horizontal to the vertical position, one of the links 55 is pushed rearward, thereby to close the connectors connected thereto, and, if a circuit board is in place in the connector to secure it in place and make electrical connections to it.

With reference to FIG. 5a and 5b, it will be recognized that means for properly positioning the modules in the rack can be provided. In this instance keying members 90 and a corresponding slot keyed in each of the circuit boards are postioned such that the keying members 90 pass through the slot when properly positioned in the slot 111. The keying members 90 are connected to the shaft 57 and are actuated by movement of the levers 53. Thus, if the module is inserted improperly into the slot 111, the keying member 90 is stopped thereby, and the connectors 17 (FIG. 5b) are prevented from contacting the board. The resilience of the links 55 prevents damage to boards and connectors when one attempts to close a connector on an improperly inserted board. As described above, closure is brought about by a rearward push of the links 55. If the connector resists closure, the force exerted by the link 55 is limited by its resilient nature, which caused an elastic buckling of the link in that situation. On the other hand, the force is not so limited during a connector-opening operation, since the link arm 55 is then under tension.

With reference to FIGS. 5, 5a and 5b, the back panel 1 is shown with a frame 110 having brackets 19 positioned thereon. The T-shaped bars 21, which are secured to the frame by suitable means, such as screws, secure the brackets 19 to the frame. The brackets 19 have U-shaped slots 111 containing the keying members 90 at their upper ends as shown in FIG. 5a. The remaining portions of the slots 111 contain the connectors 17 (FIG. 5b). Spacers 112 are secured by screws 114 to the T-shaped bars 21 approximately midway between the ends said back panel 1. Also, half-spacers 115 (FIG. 1c) are secured to brackets 29 by rivets 116 (FIG. 1c). The spacers 112 and half-spacers 115 serve to maintain the sides of the brackets 19 in the perpendicular orientation relative to the frame 110 against the tendency of the bars 21 tends to splay the sides of the brackets 19. Further, the spacers 112 and the half-spacers 115 have tapered edges which extend upwardly and outwardly from the U-shaped slots 111, such that circuit boards which are warped but guidable in tracks 11 and 13 are guided by the spacers into the slots 111 when the boards are inserted.

It will be further understood that the spacers 112 and the T-shaped bars 21 may be combined into a single bar 121, a shown in FIG. 5c. The bar 121 is secured by a suitable manner, such as screws, to the frame 110.

Thus, it will be understood and appreciated by those skilled in the art that the present rack for housing components of electronic systems is relatively small in volume, yet, it provides for ease of assembly of the rack, as well as ease of servicing of the various modules of the electronic system housed therein. The rack provides for uniform and adequate air flow for cooling of the circuit boards disposed therein, as well as parallel arrangements of the racks. The rack also provides means for remotely actuating the zero-insertion-force connectors of the rack and force limiting of such actuating means to prevent damage to the components of the rack and the circuit boards disposed therein. further, the rack provides means for inserting warped boards into the rack.

## Claims

1. A rack for mounting circuit boards having side panels (3,5) and a back panel (1) for use in electronic systems having means for generating a coolant flow through said rack, said rack further comprising :
   – a top grille (7), being connected to the top of the side panels (3, 5) and the back panel (1),
   – a bottom grille (9), being connected to the bottom of the side panels (3, 5) and the back panel (1), whereby said grilles (7, 9), the side panels (3, 5) and the back panel (1) form a frame having a rectangular cross-section,
   – said grilles (7, 9) having means for positioning a plurality of circuit boards between said grilles (7, 9) in a manner perpendicular to the grilles (7, 9),
   – and said grilles (7, 9) have apertures (32 and 33) positioned therein to permit the passage of the coolant flow, generated by the means for generating a coolant flow, through said rack and between circuit boards positioned in the rack, characterised in that
   – said apertures (32 and 33) are of such size and shape that the combined coolant flow impedance of the apertures is substantially greater than the coolant flow impedance of the circuit boards positioned therein, whereby the coolant flow through the rack is substantially independent of the arrangement of circuit boards within the rack.

2. A rack according to claim 1 further comprising rotary actuated zero-insertion force connectors (17) in said back panel (1), means for remotely actuating said rotary actuated zero-insertion force connectors including actuator shafts (57) connected to said zero insertion force connectors (17); a link member (55) connected to said actuator shafts (57); and a lever member (53) attached to said link member and rotably secured to one of said grille (7) opposite said back panel (1) whereby rotation of said lever member (53) from a first open position to a second closed position causes said link member (55) to rotate said actuator shaft (57) and thereby actuate said zero-insertion force connectors (17) into electrical contact with a circuit board disposed between said zero-insertion force connectors (17).

3. A rack according to claim 1 wherein said means for positioning said circuit boards are tracks (11 and 13) disposed in each of said grilles (7 and 9), said apertures (32 and 33) in said grilles (7 and 9) are disposed on each side and along said tracks (11 and 13), said apertures (32 and 33) have tapered edges such that the apertures through which the coolant flow enters said rack form vena contracta and the apertures that the coolant flow exits from said rack form nozzles, whereby the coolant flow through the rack is substantially uniform and without appreciable turbulence.

4. The rack of claim 1 wherein said apertures in said grilles have tapered portions flaring from the external surface of the grilles to the internal surface of the grilles adjacent the circuit boards, said apertures on the inlet side of said rack forming a plurality of vena contracta coolant ports through which said coolant flow enters said rack and the apertures on the outlet side of said rack forming a plurality of nozzles through which said coolant flow exits said rack.

5. A rack according to claim 2 wherein said link member (55) is essentially a load limiting spring when in compression such that the force applied to actuate said rotary zero-insertion-force connectors (17) is limited when said lever member (53) is moved from said first to said second position.

6. A rack according to claim 5, wherein, when said lever member (53) is moved from said second position to said first position, said link member (55) is in a substantially rigid condition.

## Patentansprüche

1. Gestellrahmen zur Anordnung von Leiterplatten, der Seitenplatten (3,5) und eine Rückplatte (1) aufweist und in elektronischen Systemen verwendbar ist, die eine Einrichtung zur Erzeugung einer Kühlmittelströmung durch den Gestellrahmen aufweisen, welcher Gestellrahmen ferner enthält:

- eine obere Gitterplatte (7), die mit der Oberseite der Seitenplatten (3,5) und der Rückplatte (1) verbunden ist,
- eine untere Gitterplatte (9), die mit der Unterseite der Seitenplatten (3,5) und der Rückplatte (1) verbunden ist, wobei die Gitterplatten (7,9), die Seitenplatten (3,5) und die Rückplatte (1) einen Rahmen mit einem rechteckförmigen Querschnitt bilden,
- welche Gitterplatten (7,9) Mittel zur Anordnung einer Mehrzahl von Leiterplatten zwischen den Gitterplatten (7,9) in einer Orientierung senkrecht zu den Gitterplatten (7,9) aufweisen, und
- welche Gitterplatten (7,9) Öffnungen (32 und 33) aufweisen, welche darin vorgesehen sind, um den Durchtritt der erzeugten Kühlmittel strömung durch den Gestellrahmen und zwischen den in dem Gestellrahmen angeordneten Leiterplatten zu ermöglichen, **dadurch gekennzeichnet, daß**
- die Öffnungen (32 und 33) eine derartige Größe und Form aufweisen, daß der kombinierte Kühlmittel-Strömungswiderstand der Öffnungen beträchtlich größer als der Kühlmittel-Strömungswiderstand der darin angeordneten Leiterplatten ist, so daß die Kühlmittelströmung durch den Gestellrahmen im wesentlichen unabhängig von der Anordnung von Leiterplatten in dem Gestellrahmen ist.

2. Gestellrahmen nach Anspruch 1, **dadurch gekennzeichnet, daß** in der Rückplatte (1) durch Drehung betätigbare Anschlußglieder (17) vorgesehen sind, für die eine Einsetzkraft nicht erforderlich ist, daß eine Einrichtung für eine Fernbetätigung der Anschlußglieder vorgesehen ist, die Betätigungsschäfte (57) aufweisen, die mit den Anschlußgliedern (17) verbunden sind, daß ein Gestängeglied (55) mit den Betätigungsschäften (57) verbunden ist, und daß ein Hebelglied (53) an dem Gestängeglied befestigt ist und drehbar an einer der Gitterplatten (7) gegenüber der Rückplatte (1) gehaltert ist, wobei eine Drehung des Hebelglieds (53) aus einer ersten offenen Lage in eine zweite geschlossene Lage verursacht, daß das Gestängeglied (55) den Betätigungsschaft (57) dreht und dadurch die Anschlußglieder (17) in elektrischen Kontakt mit einer Leiterplatte bringt, die zwischen den Anschlußgliedern (17) angeordnet ist.

3. Gestellrahmen nach Anspruch 1, **dadurch gekennzeichnet, daß** die Einrichtung zur Anordnung der Leiterplatten in jeder der Gitterplatten (7 and 9) vorgesehene Führungen (11 und 13) sind, daß die Öffnungen (32 und 33) in den Gitterplatten (7 und 9) auf jeder Seite und entlang den Führungen (11 und 13) angeordnet sind, daß die Öffnungen (32 und 33) sich verjüngende Umrandungen aufweisen, derart daß die Öffnungen, durch die die Kühlmittelströmung in den Gestellrahmen eintritt, Kontraktionen verursachen, und die Öffnungen, durch die die Kühlmittelströmung aus dem Gestellrahmen austritt, Düsen bilden, wobei die Kühlmittelströmung durch den Gestellrahmen im wesentlichen gleichförmig und praktisch nicht turbulent ist.

4. Gestellrahmen nach Anspruch 1, **dadurch gekennzeichnet, daß** die Öffnungen in den Gitterplatten sich verjüngende Teile aufweisen, die sich von der Außenfläche der Gitterplatten zu der Innenfläche der Gitterplatten angrenzend an die Leiterplatten erweitern, daß die Öffnungen auf der Einlaßseite des Gestellrahmens eine Mehrzahl von Kontraktionen bildenden Kühlmitteldurchlässen aufweisen, durch die die Kühlmittelströmung in den Gestellrahmen eintritt, und daß die Öffnungen auf der Auslaßseite des Gestellrahmens eine Mehrzahl von Düsen bilden, durch die die Kühlmittelströmung aus dem Gestellrahmen austritt.

5. Gestellrahmen nach Anspruch 2, **dadurch gekennzeichnet, daß** das Gestängeglied (55) in der Hauptsache eine belastungsbegrenzende Feder ist, derart daß die auf die Anschlußglieder (17) ausgeübte Betätigungskraft begrenzt wird, wenn das Hebelglied (53) aus der ersten in die zweite Lage bewegt wird.

6. Gestellrahmen nach Anspruch 5, **dadurch gekennzeichnet, daß** bei der Bewegung des Hebelglieds (53) aus der zweiten Lage in die erste Lage das Gestängeglied (55) sich in einem weitgehend starren Zustand befindet.

## Revendications

1. Rack pour mettre en place des cartes de circuit comportant des panneaux latéraux (3,5) et un panneau arrière (1) destiné à servir dans des systèmes électroniques comportant un moyen pour générer un flux d'une substance de refroidissement dans ledit rack, ledit rack comprenant en outre:

- une grille supérieure (7), qui est connectée au haut des panneaux latéraux (3,5) et du panneau arrière (1),
- une grille inférieure (9), qui est connectée au bas des panneaux latéraux (3,5) et du panneau arrière (1), lesdites grilles (7,9), les panneaux latéraux (3,5) et le panneau arrière (1) constituant ainsi un bâti ayant une coupe rectangulaire,
- lesdites grilles (7,9) comportant des moyens pour positionner un ensemble de cartes de circuit entre lesdites grilles (7,9) perpendiculairement aux grilles (7,9),
- et lesdites grilles (7,9) comportant des ouvertures (32,33) positionnées à l'intérieur de celles-ci pour permettre le passage du flux de substance de refroidissement , généré par le moyen pour générer un flux de substance de refroidissement, dans ledit rack et entre les cartes de circuit positionnées dans le rack, caractérisé en ce que

– lesdites ouvertures (32,33) ont des dimensions et une forme telles que l'impédance de flux de substance de refroidissement combinée des ouvertures est substantiellement supérieure à l'impédance de flux de matière de refroidissement des cartes de circuit qui y sont positionnées, la circulation de la substance de refroidissement dans le rack étant ainsi effectivement indépendante de la disposition des cartes de circuit dans le rack.

2. Rack selon la revendication 1, comprenant en outre des connecteurs à force d'insertion nulle actionnés et tournants (17) dans ledit panneau arrière (1), des moyens pour actionner à distance lesdits connecteurs à force d'insertion nulle actionnés et tournants incluant des arbres actionneurs (57) connectés auxdits connecteurs à force d'insertion nulle (17); un élément d'assemblage (55) connecté auxdits arbres actionneurs (57); et un élément levier (53) fixé audit élément d'assemblage et assujetti d'une façon rotative par rapport à une desdites grilles (7) opposée audit panneau arrière (1), la rotation dudit élément levier (53) d'une première position ouverte à une deuxième position fermée faisant ainsi en sorte que ledit élément d'assemblage (55) tourne lesdits arbres actionneurs (57) et actionne ainsi lesdits connecteurs à force d'insertion nulle (17) pour les mettre en contact avec une carte de circuit disposée entre lesdits connecteurs à force d'insertion nulle (17).

3. Rack selon la revendication 1, dans lequel lesdits moyens pour positionner lesdites cartes de circuit sont des pistes (11, 13) disposées dans chacune desdites grilles (7,9), lesdites ouvertures (32,33) formées dans lesdites grilles (7,9) sont disposées de chaque côté et le long desdites pistes (11,13), lesdites ouvertures (32,33) ont des bords biseautés de telle sorte que les ouvertures par lesquelles entre le flux de substance de refroidissement dans ledit rack constituent une "vena contracta" et les ouvertures par lesquelles sort le flux de substance de refroidissement dudit rack constituent des ajutages, la circulation de la substance de refroidissement dans le rack étant ainsi effectivement uniforme et sans turbulence appréciable.

4. Rack selon la revendication 1, dans lequel lesdites ouvertures formées dans lesdites grilles comportent des parties biseautées s'évasant de la surface externe des grilles à la surface interne des grilles au voisinage des cartes de circuit, lesdites ouvertures du côté de l'entrée dudit rack constituant un ensemble d'entrées de substance de refroidissement de type vena contracta par lesquelles ledit flux de substance de refroidissement entre dans ledit rack et les ouvertures du côté de la sortie dudit rack constituant un ensemble d'ajutages par lesquels ledit flux de substance de refroidissement sort dudit rack.

5. Rack selon la revendication 2, dans lequel ledit élément d'assemblage (55) est essentiellement un ressort de limitation de charge quand il est comprimé de telle sorte que la force appliquée pour actionner lesdits connecteurs à force d'insertion nulle tournants (17) est limitée quand ledit élément levier (53) est déplacé de ladite première à ladite deuxième position.

6. Rack selon la revendication 5, dans lequel, quand ledit élément levier (53) est déplacé de ladite deuxième position à ladite première position, ledit élément d'assemblage (55) est dans un état effectivement rigide.

FIG. I

FIG. IA

FIG. IC

FIG. IB

FIG. 2

FIG. 3

FIG. 4

FIG. 3A

FIG. 3B

FIG. 5

FIG. 5A

FIG. 5B

FIG. 5C

FIG. 6

FIG. 6A